(19) Europäisches Patentamt
European Patent Office
Office européen des brevets

(11) **EP 4 766 127 A1**

(12) **EUROPEAN PATENT APPLICATION**
published in accordance with Art. 153(4) EPC

(43) Date of publication:
**24.06.2026 Bulletin 2026/26**

(21) Application number: **24856402.3**

(22) Date of filing: **16.08.2024**

(51) International Patent Classification (IPC):
*H10N 60/12* (2023.01)

(52) Cooperative Patent Classification (CPC):
**H10N 60/12**

(86) International application number:
**PCT/JP2024/029139**

(87) International publication number:
**WO 2025/041713 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.08.2023 JP 2023133316**

(71) Applicant: **Japan Science and Technology
Agency
Kawaguchi-shi, Saitama 332-0012 (JP)**

(72) Inventors:
• **SUNADA Yoshiki
Tokyo 153-8904 (JP)**
• **NAKAMURA Yasunobu
Tokyo 153-8904 (JP)**

(74) Representative: **Noble, Nicholas et al
Kilburn & Strode LLP
Lacon London
84 Theobalds Road
London WC1X 8NL (GB)**

(54) **QUANTUM DEVICE AND QUANTUM COMPUTER**

(57) A quantum device 10 comprises a data qubit 11, a readout resonator 12 coupled with the data qubit 11 and a nonlinear filter 14 inserted between the readout resonator 12 and a readout waveguide 13. The nonlinear filter 14 has different transparency depending on the amplitude of the readout pulse input to the readout waveguide 13.

FIG. 1

EP 4 766 127 A1

## Description

This disclosure relates to a quantum device and quantum computer.

BACKGROUND ART

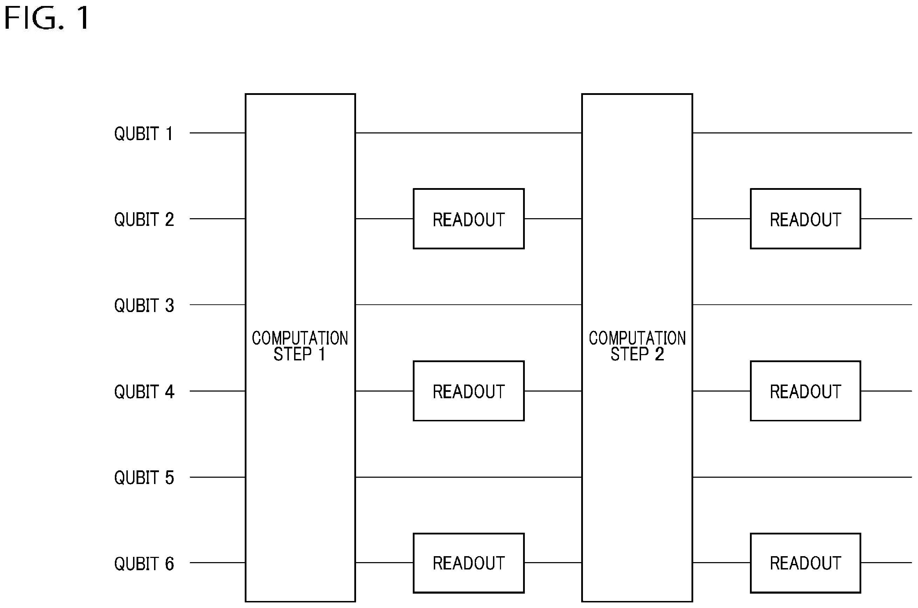

Quantum computers use elements, called qubits, to process information, and they have a computing power that exceeds that of existing computers. However, compared to the classical bits used by existing computers, qubits are more susceptible to noise, therefore it is necessary to use a technique called fault-tolerant quantum computation to realize a general-purpose quantum computer. In fault-tolerant quantum computation, the state of some qubits is read out between each computation step in order to detect computation errors caused by noise. Figure 1 schematically shows a fault-tolerant quantum computation. In the example in this figure, six qubits, i.e., qubits 1-6, are implemented, and the states of qubits 2, 4, and 6 are read out between computation step 1 and computation step 2. In order to make such fault-tolerant quantum computation practical, it is necessary to read out the states of the qubits at high speed and with high precision.

In superconducting qubits, one of the leading implementations of qubits, high-speed and high-precision readout is achieved by a technique called dispersive readout, see, for example, Non-Patent Literature 1. Hereafter, unless otherwise noted, we call superconducting qubits simply "qubits" for short. In dispersive readout, a microwave resonator called a "readout resonator" is coupled to a qubit, and the phenomenon that its resonance frequency changes according to the state of the qubit is exploited. The stronger the coupling between the qubit and the readout resonator, the greater the change in resonance frequency. This allows for faster and more precise readout. However, this makes the qubit more sensitive to thermal noise in the readout resonator, which shortens the time that the qubit can retain information.

Conventionally, the main problem in achieving faster and more precise readout of qubits has been the reduction of the energy relaxation time due to the outflow of energy from the qubit through the readout resonator. To solve this problem, a linear filter called a Purcell filter was developed, see, for example, Non-Patent Literature 2-8. Furthermore, it has been demonstrated that a nonlinear filter called the Josephson quantum filter can also suppress the outflow of energy into the waveguide for qubit control, see, for example, Non-Patent Literature 9-11.

Prior art references.

RELATED-ART LITERATURES

NON PATENT LITERATURES

Non-Patent Literature 1: T. Walter et al., "Rapid high-fidelity single-shot dispersive readout of superconducting qubits", Physical Review Applied 7 (May 26, 2017), p. 054020.
Non-Patent Literature 2: M. D. Reed et al., "Fast reset and suppressing spontaneous emission of a superconducting qubit", Applied Physics Letters 96, 203110 (2010).
Non-Patent Literature 3: E. Jeffrey et al., "Fast accurate state measurement with superconducting qubits", Physical Review Letters 112 , 190504 (2014).
Non-Patent Literature 4: E. A. Sete et al., "Quantum theory of a bandpass Purcell filter for qubit readout", Physical Review A 92, 012325 (2015).
Non-Patent Literature 5: N. T. Bronn et al., "Broadband filters for abatement of spontaneous emission in circuit quantum electrodynamics",. Applied Physics Letters 107, 172601 (2015).
Non-Patent Literature 6: N. T. Bronn et al., "Reducing spontaneous emission in circuit quantum electrodynamics by a combined readout/filter technique", IEEE Transactions on Applied Superconductivity 25, 1700410 (2015).
Non-Patent Literature 7: L. C. G. Govia et al., "Enhanced qubit readout using locally generated squeezing and inbuilt Purcell-decay suppression", New Journal of Physics 19, 023044 (2017).
Non-Patent Literature 8: Y. Sunada et al., "Fast readout and reset of a superconducting qubit coupled to a resonator with an intrinsic Purcell filter Physical", Physical Review Applied 17, 044016 (2022).
Non-Patent Literature 9: K. Koshino et al., "Protection of a Qubit via Subradiance: A Josephson Quantum Filter", Physical Review Applied 13, 014051 (2020).
Non-Patent Literature 10: S. Kono et al., "Breaking the trade-off between fast control and long lifetime of a superconducting qubit", Nature Communications 11, 3683 (2020). Non-Patent Literature 11: I. Iakoupov et al., "Saturable Purcell filter for circuit quantum electrodynamics", Physical Review Research 5, 013148 (2023).
Non-Patent Literature 12: J.-H. Yeh et al., "Microwave attenuators for use with quantum devices below 100 mK", Journal of Applied Physics 121 , 224501 (2017).
Non-Patent 13: F. Yan et al, "Distinguishing Coherent and Thermal Photon Noise in a Circuit Quantum Electrodynamical System", Physical Review Letters 120, 260504 (2018).
Non-Patent Literature 14: Z. Wang et al., "Cavity attenuators for superconducting qubits", Physical Review Applied 11, 014031 (2019).
Non-Patent Literature 15: A. Blais et al, "Circuit quantum electrodynamics", Reviews of Modern Physics 93, 025005 (2021).

## SUMMARY OF INVENTION

### TECHNICAL PROBLEM

The information held by a qubit is lost through two processes, i.e., energy relaxation and phase relaxation. The energy relaxation is the process by which a qubit transitions from a state in which it has energy, |e>, to a state in which it does not have energy, |g>. On the other hand, phase relaxation is the process in which information on the phase of the quantum mechanical superposition between |e> and |g> is lost. The typical times for energy relaxation and phase relaxation are called energy relaxation time, "T1", and phase relaxation time, "T2", respectively.

With the development of the above prior art, the energy relaxation time T1 can now be sufficiently long for the time required to read out a qubit. Accordingly, the time in which a qubit can retain information is now limited more strongly by the phase relaxation time T2 than by T1. Thus, improving T2 has become a challenge in recent years.

The present disclosure was made in view of these problems, and general purpose of the present disclosure is to provide a technique that can increase the phase relaxation time while reducing the qubit readout time.

### SOLUTION TO PROBLEM

In order to solve the above problem, a quantum device in an aspect of the present invention comprises a data qubit, a readout resonator coupled with the data qubit and a nonlinear filter inserted between the readout resonator and a readout waveguide. The nonlinear filter has different transparency depending on the amplitude of the readout pulse input to the readout waveguide.

In one embodiment, the nonlinear filter has high transparency for input signals of small amplitude and low transparency for input signals of large amplitude.

In one embodiment, the nonlinear filter has a transparency such that $\kappa_{\text{eff}} \gg \chi$ when no readout of the data qubit is performed and $\kappa_{\text{eff}} = \chi$ during readout, where the line width of the coupling between the readout resonator and the readout waveguide through the nonlinear filter is $\kappa_{\text{eff}}$ and the dispersion shift of the readout resonator due to the data qubit is $\chi$.

In one embodiment, the nonlinear filter comprises a superconducting qubit.

In one embodiment, the nonlinear filter has the following features of:

[Equation 8]

$$|\omega_f - \omega_r| \ll \kappa, \qquad (4)$$

[Equation 9]

$$\alpha_f \gtrsim \kappa, \qquad (5)$$

[Equation 10]

$$\kappa \approx 4g, \qquad (6)$$

[Equation 11]

$$\kappa \gg \chi \qquad (7)$$

where the transition frequency of the nonlinear filter is $\omega_f$, the anharmonicity of the nonlinear filter is $\alpha_f$, the resonance frequency of the readout resonator is $\omega_r$, the coupling strength between the readout resonator and the nonlinear filter is g and the line width of coupling between the nonlinear filter and the readout waveguide is $\kappa$.

In one embodiment, the superconducting qubit comprises a transmon consisting of a Josephson junction and a capacitor coupled with each other in parallel.

In one embodiment, the nonlinear filter and the readout waveguide are capacitively coupled.

In one embodiment, the nonlinear filter and the readout waveguide are inductively coupled.

Another aspect of the invention is a quantum computer. This quantum computer comprises one of the aforementioned quantum devices.

Any combination of the above components, and any conversion of the expression of the invention between devices, methods, systems, recording media, computer programs, etc., is also valid as an aspect of the invention.

ADVANTAGEOUS EFFECTS OF INVENTION

According to the present invention, the phase relaxation time can be increased while the qubit readout time is reduced.

BRIEF DESCRIPTION OF DRAWINGS

[FIG. 1] Fig. 1 is a schematic diagram showing error tolerant quantum computation.

[FIG. 2] Fig. 2 is a schematic diagram of the system used for dispersive readout.

[FIG. 3] Fig. 3 is a schematic diagram of a quantum device comprising a conventional linear filter.

[FIG. 4] Fig. 4 is a schematic diagram of a quantum device according to the first embodiment.

[FIG. 5] is a graph showing the relationship between the line width of the readout resonator and the phase relaxation rate.

[FIG. 6] Fig. 6 is a graph showing the relationship between the frequency and the transmittance of the filter according to the embodiment.

[FIG. 7] Fig. 7 is a schematic diagram showing the parameters for the design of the filter qubits.

[FIG. 8] Fig. 8 is a schematic diagram of the nonlinear filter of the quantum device according to the second embodiment.

[FIG. 9] Fig. 9 is a schematic diagram of a quantum device according to the third embodiment.

[FIG. 10] Fig. 10 is a schematic diagram of a quantum device according to the fourth embodiment.

[FIG. 11] Fig. 11 shows an experimental result of the wavelength characteristics of the non-linear filter according to the present disclosure.

[FIG. 12] Fig. 12 shows a numerical simulation result of the wavelength characteristics of the non-linear filter according to the present disclosure.

[FIG. 13] Fig. 13 is a graph showing the relationship between the amplitude of the readout signal and the signal separation obtained from the experimental result of Fig. 11.

[FIG. 14] Fig. 14 a graph showing the temporal change of the readout signal in the excited state and the ground state. Fig 14(a) corresponds to a readout pulse length of 200 ns and Figure 14(b) corresponds to a readout pulse length of 40 ns.

[FIG. 15] Fig. 15 a graph showing the phase of the steady-state reflection coefficient of the nonlinear filter with respect to the frequency and amplitude of the input signal.

[FIG. 16] Fig. 16 a graph showing the observed measurement rate as a function of the amplitude of the readout pulse.

[FIG. 17] Fig. 17 a graph showing the complex amplitude of the readout signal in the excited and ground states, measured using a 2 microsecond square pulse.

DESCRIPTION OF EMBODIMENTS

The invention will be described below with reference to the drawings based on suitable embodiments. The embodiments are examples rather than limitations of the invention. All features or combinations of features described in the embodiments are not necessarily essential to the invention. Identical or equivalent components, parts, and processes shown in each drawing shall be given the same symbol, and duplicate explanations will be omitted where appropriate. The scale and shape of each part shown in each drawing are set for convenience in order to facilitate explanation and are not to be construed as limiting unless otherwise noted. When terms such as "first," "second," etc. are used in this specification or in the claims, unless otherwise mentioned, these terms do not indicate any order or degree of importance but are intended only to distinguish one configuration from another. In addition, in each drawing, some parts of the components that are not important in explaining the form of the product are omitted.

Before describing the specific embodiments, we will first explain the basic findings. As mentioned above, the higher the speed and precision of the dispersive readout of qubits, the more sensitive the qubits become to thermal noise in the readout resonator, resulting in a shorter phase relaxation time T2. This problem has conventionally been solved by suppressing the thermal noise entering from the readout waveguide coupled to the readout resonator.

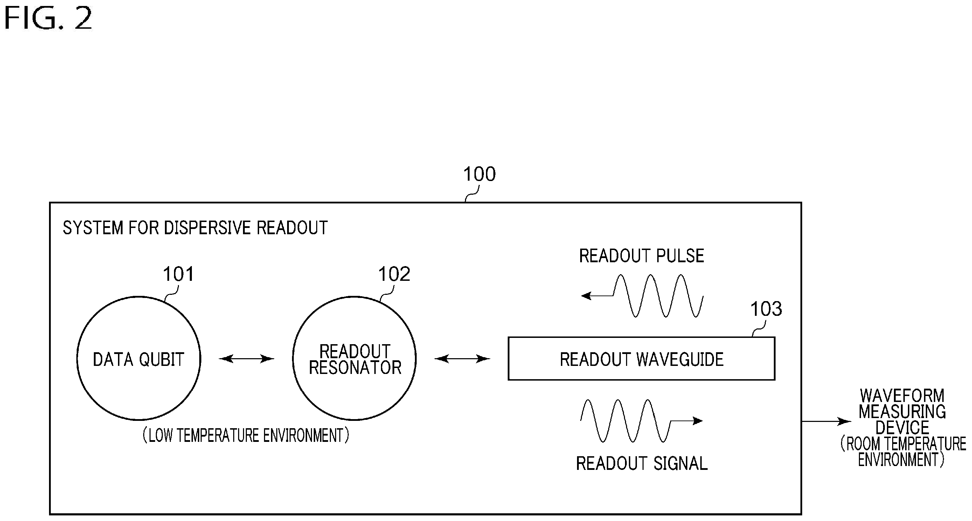

Let us now explain the dispersive readout of qubits. For dispersive readout, a system in which a readout resonator is coupled to a qubit and a readout waveguide is coupled to the readout resonator is used. Figure 2 schematically shows a system 100 used for such dispersive readout. The system 100 has data qubits 101, a readout resonator 102 and a readout waveguide 103. The data qubits 101 are coupled to the readout resonator 102, and the readout resonator 102 is coupled to the readout waveguide 103.

To perform readout, a microwave pulse having a frequency resonant with the readout resonator 102, hereinafter referred to as "readout pulse", id injected from the readout waveguide 103. Here, since the readout resonator 102 is coupled to the data qubit 101, the resonant frequency changes depending on the state of the data qubit 101. Thus, the reflection coefficient of the readout pulse also changes. Thus, by measuring the phase and amplitude of the reflected wave, hereinafter referred to as "readout signal", after the readout pulse is injected into readout resonator 102, the state of data qubit 101 can be determined.

The readout signal must be measured by a waveform measuring device placed in a room temperature environment. On the other hand, the data qubits 101 and the readout resonator 102 must be cooled to tens of mK (millikelvin) using a dilution refrigerator and kept in a low temperature environment. Therefore, if the readout resonator 102 is directly connected to the waveform measurement device by a readout waveguide 103, thermal radiation from the room temperature environment will flow back through the readout waveguide 103 and into the readout resonator 102. This causes thermal noise. To prevent this, a microwave element called an isolator, which passes in the forward direction but attenuate in the reverse direction, has conventionally been used. However, with current technology, it is difficult to miniaturize an isolator. Therefore, it is difficult to accommodate the required number of isolators in the dilution refrigerator of a practical quantum computer. Even in experiments using a large number of isolators connected together, the average number of thermal photons in the readout resonator 102 can currently only be suppressed to about $10^{-3}$ to $10^{-4}$, see, for example, Non-Patent Literature 12-14.

This value is more than 10,000 times larger than the average thermal photon number of $10^{-8}$ expected from about 20 mK, i.e., the temperature of the dilution refrigerator. This is believed to be due to the difficulty of adequately dissipating heat from the various microwave elements connected to the readout waveguide 103 at cryogenic temperatures, see, for example, Non-Patent Literature 14. For these reasons, in order to improve the phase relaxation time T2 of data qubits 101 in the future, it is considered necessary to use approaches other than suppression of thermal noise entering from the readout waveguide 103 in combination.

As a new approach to improve the phase relaxation time T2 of qubits, the inventors have devised a technique to provide thermal noise tolerance to the readout circuit itself. This makes it possible to suppress the phase relaxation of qubits without suppressing the inflow of thermal noise into the readout resonator. In this disclosure, a nonlinear filter is used to achieve this. The following is a description of the unique features of the nonlinear filter of the present disclosure compared to conventional linear filters.

Conventional linear filter

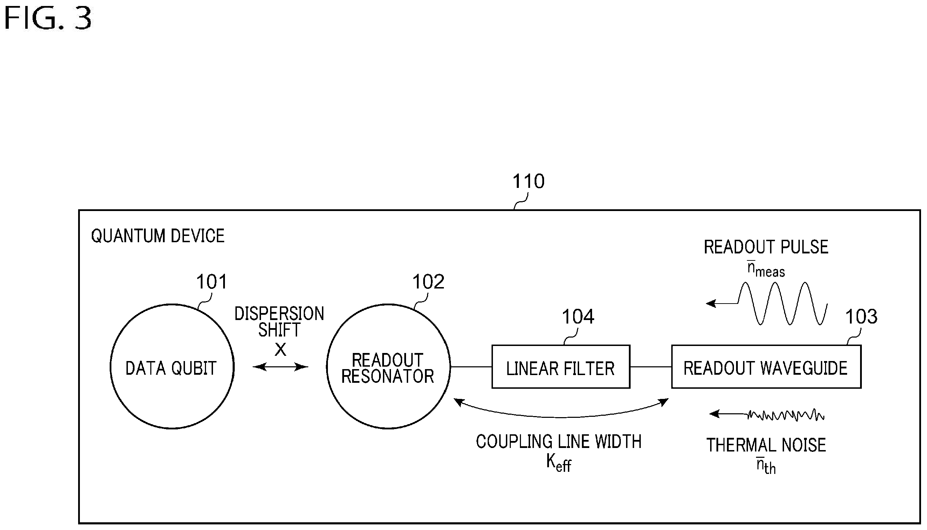

Figure 3 schematically shows a quantum device 110 comprising a conventional linear filter. The quantum device 110 comprises data qubits 101, a readout resonator 102, a readout waveguide 103 and a linear filter 104. The readout resonator 102 and the readout waveguide 103 are coupled through the linear filter 104.

The speed at which the data qubits 101 undergo phase relaxation is represented by the phase relaxation rate $\Gamma$, which is the reciprocal of the phase relaxation time T2. In particular, the phase relaxation rate $\Gamma^{th}_{\phi}$ of the qubits due to thermal noise in the readout resonator 102 is expressed by the following equation.

[Equation 1]

$$\Gamma^{\text{th}}_{\phi} = \frac{\kappa_{\text{eff}} \chi^2}{\kappa_{\text{eff}}^2 + \chi^2} \bar{n}_{\text{th}} \qquad (1)$$

Where, :

[Equation 2]

$$\bar{n}_{\text{th}}$$

is the average number of thermal photons in the readout resonator 102 under normal conditions. $\chi$ is the change in the resonance frequency of the readout resonator 102 in response to the state of the data qubit 101, hereafter referred to as the "dispersion shift". $\kappa_{\text{eff}}$ is the line width of the coupling between the readout resonator 102 through the linear filter 104 and the readout waveguide 103. For dispersive readout in this system, the dispersion shift $\chi$ of the readout resonator 102 and the line width $\kappa_{\text{eff}}$ must be the same, see, for example, Non-Patent Literature 15. Equation (1) can then be approximated as follows.

[Equation 3]

$$\Gamma_\phi^{\text{th}} \approx \frac{\chi}{2}\bar{n}_{\text{th}} \qquad (2)$$

In other words, if the dispersion shift $\chi$ is increased in order to improve the speed and accuracy of readout, the phase relaxation rate $\Gamma^{\text{th}}_\phi$ due to thermal noise also increases proportionally.

To understand the fundamental nature of this trade-off, it is necessary to take the viewpoint that reading out a qubit state is to phase-relax a qubit intentionally. When a qubit in the superposition state of |g> and |e> is read out, the information is converted to a classical bit, and the phase information of the superposition is lost. In dispersive readout, this process occurs gradually and can be regarded as phase relaxation. This is called measurement-induced phase relaxation. Since the measurement-induced phase relaxation rate is the rate at which the information in the qubits is converted to classical bits, a large rate is required for fast and accurate readout.

Assume that the average number of photons in the readout resonator 102 produced by the readout pulse is:

[Equation 4]

$$\bar{n}_{\text{meas}}$$

Then, the measurement-induced phase relaxation rate in the dispersion readout is represented as:

[Equation 5]

$$\Gamma_\phi^{\text{meas}} = \frac{2\kappa_{\text{eff}}\chi^2}{\kappa_{\text{eff}}^2 + \chi^2}\bar{n}_{\text{meas}} \qquad (3)$$

Here, the frequency of the readout pulse is the average of the resonance frequencies of the readout resonator when the data qubits are in the |g> and |e> states. Equation (1) has exactly the same form as Equation (3) except for the doubling factor. This is due to the fact that the phase relaxation due to thermal noise can be regarded as measurement-induced phase relaxation due to a broadband readout pulse. In other words, dispersive readout of data qubits and phase relaxation due to thermal noise are thought to be caused by the same mechanism.

From the above discussion, it is clear that the ratio between the phase relaxation rate $\Gamma^{\text{meas}}_\phi$ during readout and the phase relaxation rate $\Gamma^{\text{th}}_\phi$ due to thermal noise under normal conditions must be large in order to achieve both high-speed, high-precision readout and a long phase relaxation time T2. According to Equations (1) and (3), in order to achieve this, the ratio of the average number of photons in the readout resonator by the readout pulse:

[Equation 4]

$$\bar{n}_{\text{meas}}$$

and the average number of photons in the normal state:

$$[\text{Equation } 2]$$

$$\bar{n}_{\text{th}}$$

must be large.

However, for dispersion readout, only about $10^1$ readout pulses can be used at most for the average number:

$$[\text{Equation } 4]$$

$$\bar{n}_{\text{meas}}$$

On the other hand, the average thermal photon number:

$$[\text{Equation } 2]$$

$$\bar{n}_{\text{th}}$$

can only be suppressed to about $10^{-4}$ even with isolators. Therefore, in the present situation, this ratio:

$$[\text{Equation } 6]$$

$$\bar{n}_{\text{meas}}/\bar{n}_{\text{th}}$$

to be larger than about $10^5$ is difficult to achieve. Therefore, in order to increase the ratio of the phase relaxation rate during readout and in normal operation, $\Gamma^{\text{meas}}_{\varphi}/\Gamma^{\text{th}}_{\varphi}$, in the future, the proportionality between the average number of photons in the readout resonator 102:

$$[\text{Equation } 7]$$

$$\bar{n}$$

and the phase relaxation rate $\Gamma_{\varphi}$ must be broken.

The first embodiment

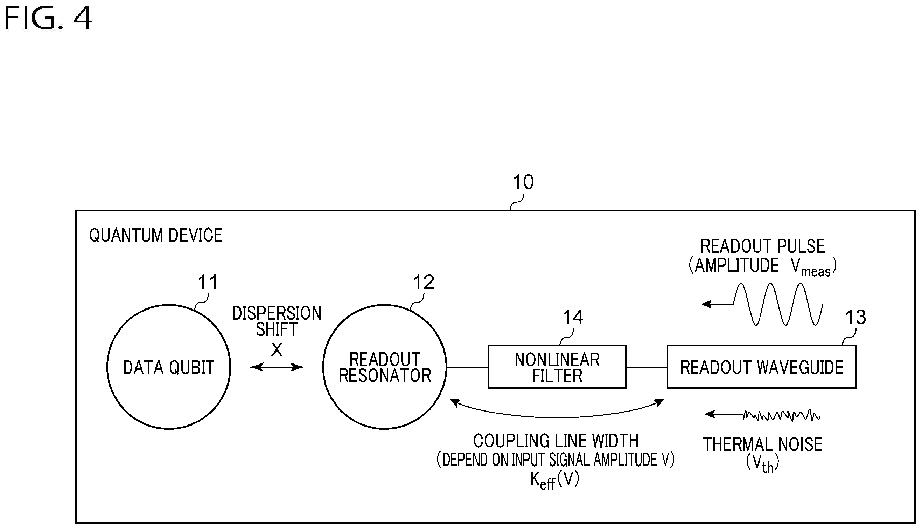

Figure 4 schematically shows a quantum device 10 comprising a nonlinear filter according to the first embodiment. The quantum device 10 comprises data qubits 11, a readout resonator 12, a readout waveguide 13 and a nonlinear filter 14. The readout resonator 12 and the readout waveguide 13 are coupled through the nonlinear filter 14.
In this embodiment, in order to break the proportionality relationship between the average photon number of readout resonator 12:

[Equation 7]

$$\bar{n}.$$

and the phase relaxation rate $\Gamma^{mas}_{\varphi}$, a nonlinear bandpass filter 14 is inserted between the readout resonator 12 and the readout waveguide 13. When a conventional linear bandpass filter is inserted, it is called a parcel filter. To distinguish the embodiment from this, the nonlinear filter 14 in the embodiment is also called a "nonlinear parcel filter".

Existing linear parcel filters selectively suppress only the energy relaxation of qubits by making the coupling between the readout resonator and the readout waveguide be dependent on frequency. This is possible because, in dispersive readout, the transition frequency of the qubit is different from the frequency of the readout pulse. However, the thermal noise in question in this embodiment has a broadband spectrum. In this broadband spectrum, the component that has the same frequency as that of the readout pulse causes phase relaxation. Therefore, it is not possible to distinguish thermal noise from readout pulse in terms of frequency. Therefore, this embodiment focuses on the difference in amplitude between thermal noise and readout pulse. In other words, our new idea is to selectively suppress the effect of thermal noise by using a nonlinear filter whose transmittance depends on the amplitude of the input signal.

Simply considered, it may seem that only thermal noise can be blocked by using a filter that blocks input signals with small amplitude and transmits input signals with large amplitude. However, in this embodiment, on the contrary, a filter that transmits input signals with small amplitude well and transmits input signals with large amplitude poorly is used. The following explains how the use of such a filter can suppress the effects of thermal noise.

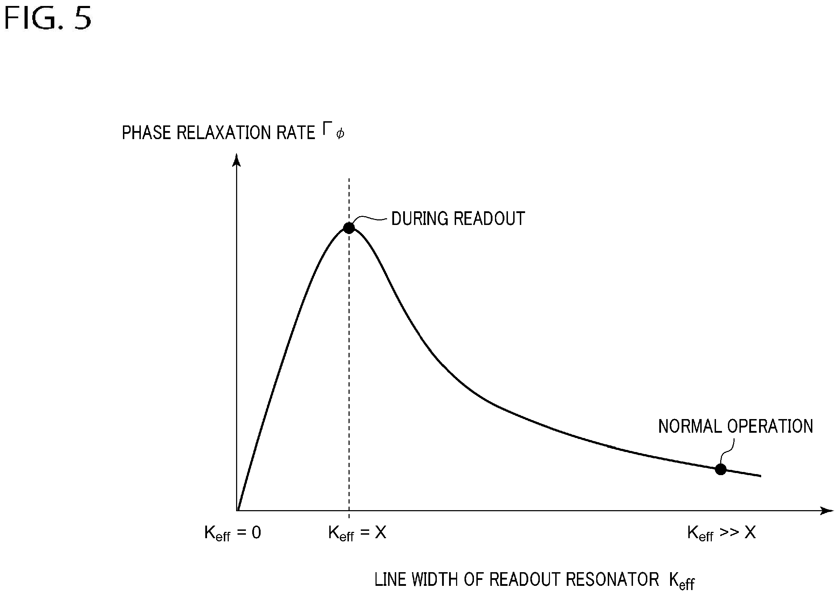

For dispersive readout, the line width $\kappa_{eff}$ of the coupling between the readout resonator 12 and the readout waveguide 13 through the nonlinear filter 14 must be equal to the dispersion shift $\chi$ of the readout resonator. This is due to the fact that, from equation (3), the measurement-induced phase relaxation rate $\Gamma^{meas}_{\varphi}$ during readout, hereinafter referred to as "readout rate", is maximum at $\kappa_{eff} = \chi$. This can be seen from Figure 5, which shows the relationship between the line width of the readout resonator and the phase relaxation rate.

When $\kappa_{eff} \to \infty$, $\Gamma^{meas}_{\varphi} \to 0$. This shows that if the line width $\kappa_{eff}$ of the readout resonator 12 is too large, the readout rate approaches 0. The reason for this is that if the line width $\kappa_{eff}$ of the readout resonator 12 is too large, the readout pulse that enters the readout resonator 12 is immediately output as a readout signal, and the time available to interact with the data qubit is short. Similarly, from Equation (1), the phase relaxation rate $\Gamma^{th}_{\varphi}$ due to thermal noise is also maximum at $\kappa_{eff} = \chi$ and approaches 0 when $\kappa_{eff} \to \infty$. In other words, if the line width $\kappa_{eff}$ of the readout resonator 12 is varied so that $\kappa_{eff} \gg \chi$ during normal operation, i.e., when no readout is performed, and $\kappa_{eff} = \chi$ during readout, the effect of phase relaxation due to thermal noise can be suppressed without impairing the readout rate. To achieve this, a nonlinear filter 14, which is highly transparent to input signals of small amplitude and less transparent to input signals of large amplitude, is inserted between the readout resonator 12 and the readout waveguide 13 in this system. As a result, during normal operation, i.e., when no readout is performed, the coupling between the readout resonator 12 and the readout waveguide 13 is strong and $\kappa_{eff} \gg \chi$ is satisfied. On the other hand, during the injection of readout pulse, the coupling becomes weaker and a readout circuit can be realized such that $\kappa_{eff} = \chi$ is satisfied.

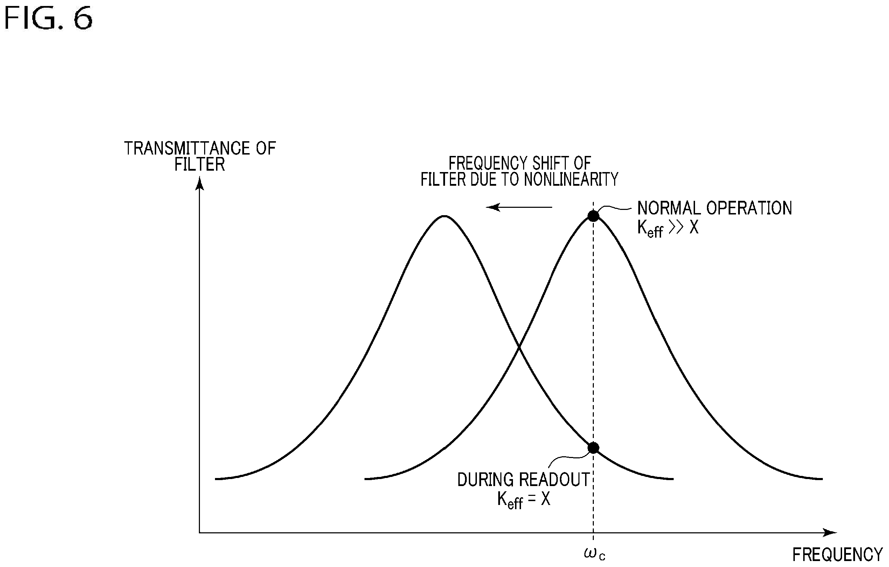

The inventors have found that, in the present invention, a superconducting qubit can be used to realize a nonlinear filter 14 that is highly transparent to input signals of small amplitude and less transparent to input signals of large amplitude. The superconducting qubits coupled with input and output ports operate as a nonlinear bandpass filter. When the amplitude of the input signal is sufficiently small, this filter transmits only signals near the transition frequency of the qubit. On the other hand, as the amplitude of the input signal is increased, the pass frequency shifts according to the anharmonicity of the qubit. The anharmonicity is explained below. Nonlinear LC circuits based on Josephson junctions and the like have a cosine-type potential, and the difference appears in the level structure. The deviation from the harmonic potential is expressed by the parameter anharmonicity $\alpha = E_{12} - E_{01}$, which is an indicator of how close to an ideal two state system the circuit is. Here, $E_{01}$ is the level difference between the ground state and the first excited state, and $E_{12}$ is the level difference between the second and first excited states. Figure 6 shows the relationship between frequency and the transmittance of this nonlinear filter. Such a filter can be realized by using a qubit whose transition frequency is equal to the frequency of the readout pulse and whose anharmonicity is sufficiently large. Hereafter, a nonlinear parcel filter realized using such qubit will be referred to as "filter qubit" to distinguish it from data qubit.

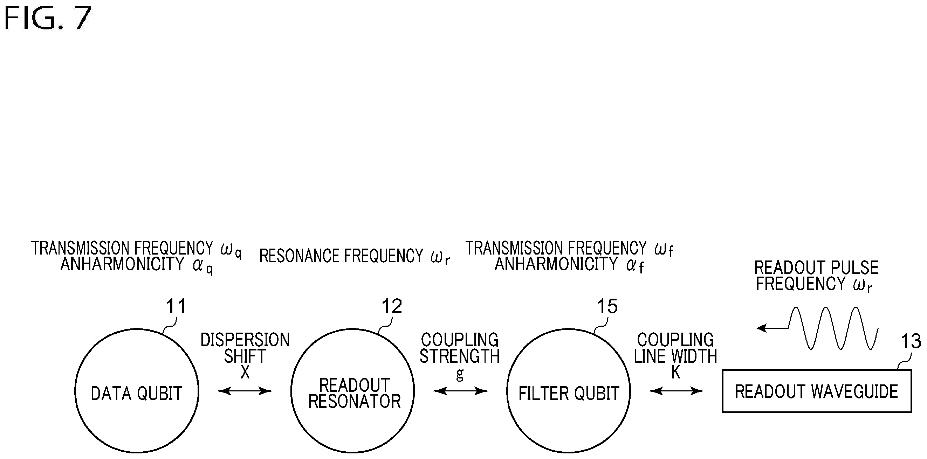

A Filter qubit is characterized by the following four parameters: transition frequency $\omega_f$, anharmonicity $\alpha_f$, coupling strength g with readout resonator 12 and line width $\kappa$ of coupling with readout waveguide 13. Figure 7 shows schematically these parameters for the design of filter qubit 15.

The conditions for this filter to operate as a nonlinear Purcell filter are given by the following four equations.
[Equation 8]

$$|\omega_f - \omega_r| \ll \kappa, \qquad (4)$$

[Equation 9]

$$\alpha_f \gtrsim \kappa, \qquad (5)$$

[Equation 10]

$$\kappa \approx 4g, \qquad (6)$$

[Equation 11]

$$\kappa \gg \chi \qquad (7)$$

Equation (4) is the condition that the filter's normal transmission bandwidth includes the resonance frequency $\omega_r$ of the readout resonator. Equation (5) is the condition that the shift of the filter's pass frequency is greater than the transmission bandwidth. These two conditions result in a nonlinear filter with high transparency for input signals of small amplitude and low transparency for input signals of large amplitude. In addition to these conditions, equations (6) and (7) must be satisfied to reduce the effect of thermal noise in normal conditions. When equation (6) is satisfied, the two resonance modes generated by the coupling of the readout resonator and the filter qubit both have resonance frequency $\approx$ $\omega_r$ and line width $\kappa_{eff} \approx \kappa/2$. If equation (7) is further satisfied, the line widths of the two resonant modes both satisfy $\kappa_{eff} \gg \chi$, and the phase relaxation due to thermal noise is suppressed.

According to this embodiment, the phase relaxation time can be increased while the qubit readout time is reduced.

Implementation Advantages of Nonlinear Purcell Filter

The principle advantages of this embodiment have been explained above. In addition to this, the nonlinear parcel filter also has some advantages with regard to implementation. In order to realize a large-scale quantum computer consisting of many superconducting qubits, it is desirable that the readout circuit for each qubit be as simple as possible to implement. In this respect, the nonlinear parcel filter has the following three advantages.

First, since the filter is implemented by superconducting qubits, the fabrication recipe of the chip is not complicated. Usually, mounting nonlinear devices that play different roles on the same chip requires multiple electron beam lithographies because Josephson junctions with different properties are needed. This deteriorates the overall chip yield and performance because impurities on the chip increase with each lithography and the yield rate in the fabrication of Josephson junctions is not 100%. On the other hand, the characteristics of the filter qubits required to implement a nonlinear Purcell filter are almost the same as those of the qubits responsible for quantum computation, hereinafter referred to as "data qubits". Therefore, the filter qubit and data qubit can be fabricated simultaneously. Therefore, a chip comprising an additional nonlinear parcel filter can be fabricated using the same recipe that has been optimized for yield and performance of the data qubits. This has become increasingly important in recent years, when chip fabrication recipes have been highly optimized.

Second, nonlinear Purcell filters can also play the role of existing linear Purcell filters. Existing bandpass parcel filters suppress the energy relaxation of qubits into the readout waveguide by inserting a filter between the readout resonator and the readout waveguide to make the coupling be dependent on frequency. The nonlinear Purcell filter suppresses the phase relaxation due to thermal noise of the qubits by utilizing the difference in transmittance dependent on the amplitude of the input signal, however it also has the same frequency dependence as the existing bandpass Purcell filter. Therefore, both the energy relaxation time T1 and the phase relaxation time T2 can be improved with a nonlinear parcel filter alone, without the need for a separate filter to suppress energy relaxation. Since many recent chips are already equipped with a bandpass Purcell filter, simply replacing it with a nonlinear Purcell filter will provide additional thermal noise tolerance. This is important for large-scale superconducting quantum computers in terms of chip area savings.

Third, no additional control is required other than injecting a readout pulse. Equation (1), which gives the phase relaxation rate of a qubit due to thermal noise, shows that the effect of thermal noise can be suppressed if the dispersion shift $\chi$ or the line width $\kappa_{eff}$ of the readout resonator can be controlled. For example, if the values of $\chi$ and $\kappa_{eff}$ are changed during normal operation and during readout using a Superconducting Quantum Interference Device (SQUID) and magnetic flux bias lines, both high-speed, high-precision readout and thermal noise tolerance can be achieved. However, adding one magnetic flux bias line per qubit consumes chip area and increases the wiring density and heat inflow of the refrigerator, which is a barrier to the large-scale development of quantum computers. In contrast, the nonlinear parcel filter is an element that automatically changes $\kappa_{eff}$ according to the presence or absence of readout pulses, therefore no additional control lines are required. In other words, the nonlinear Purcell filter can be introduced simply by changing the chip design, using the same wiring and experimental apparatus designed for dispersive readout of superconducting qubits. Since the development of experimental equipment specialized for controlling and dispersive readout of superconducting qubits has been rapidly progressing in recent years, being able to use it as is a great advantage.

The second embodiment

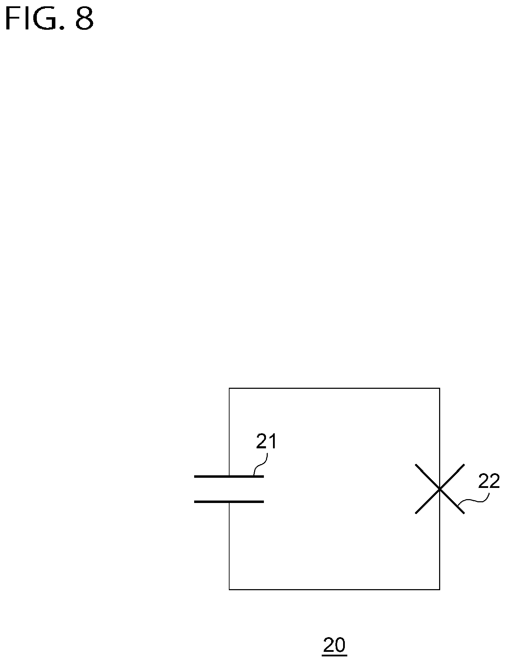

Figure 8 schematically shows a nonlinear filter 20 of the quantum device according to the second embodiment. This nonlinear filter comprises a transmon consisting of a capacitor 21 and a Josephson junction 22 coupled in parallel with each other.

According to this embodiment, a nonlinear filter can be simply fabricated as a superconducting qubit.

The third Embodiment

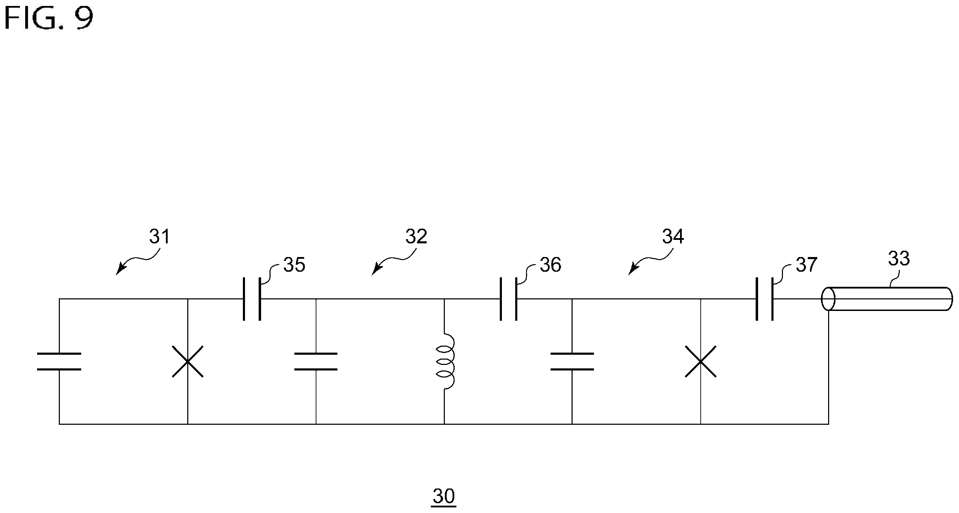

Figure 9 schematically shows a quantum device 30 according to the third embodiment. The quantum device 30 comprises data qubits 31, a readout resonator 32, a readout waveguide 33 and a nonlinear filter 34.

The data qubits 31 and the readout resonator 32 are capacitively coupled via a capacitor 35. The readout resonator 32 and the nonlinear filter 34 are capacitively coupled via a capacitor 36. The readout waveguide 33 and the nonlinear filter 34 are capacitively coupled via capacitor 37.

The fourth embodiment

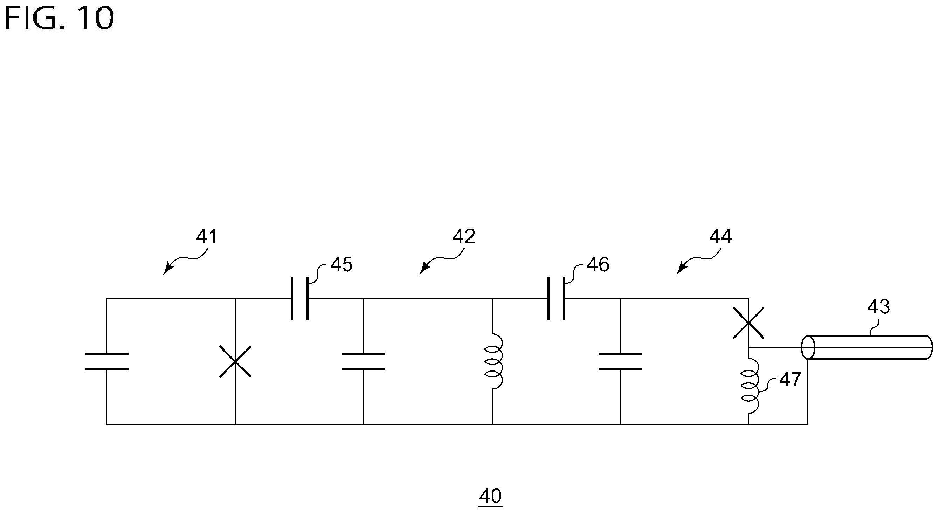

Figure 10 schematically shows a quantum device 40 according to the fourth embodiment. The quantum device 40 comprises data qubits 41, a readout resonator 42, a readout waveguide 43 and a nonlinear filter 44.

The data qubit 41 and the readout resonator 42 are capacitively coupled via a capacitor 45. The readout resonator 42 and the nonlinear filter 44 are capacitively coupled via a capacitor 46. The readout waveguide 43 and the nonlinear filter 44 are inductively coupled via an inductor 47.

Verification

The inventors conducted verification experiments to confirm the effectiveness of the quantum device according to the embodiment.

(Experiment 1)

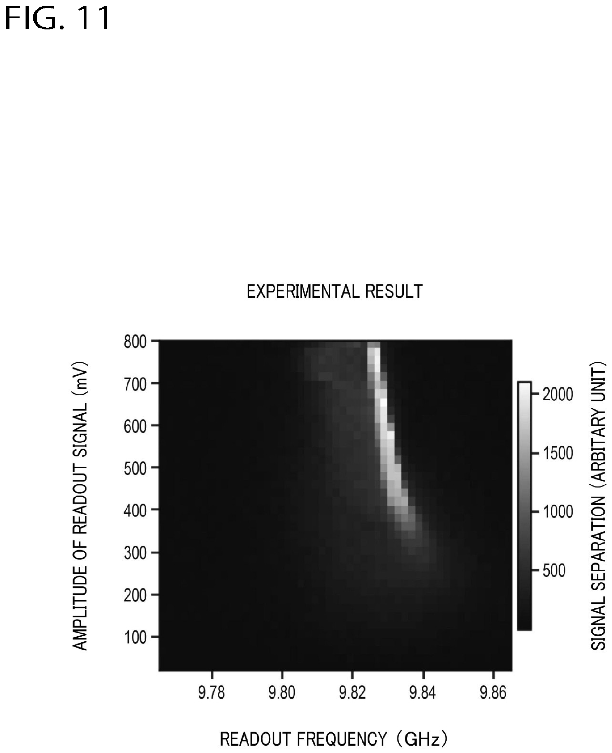

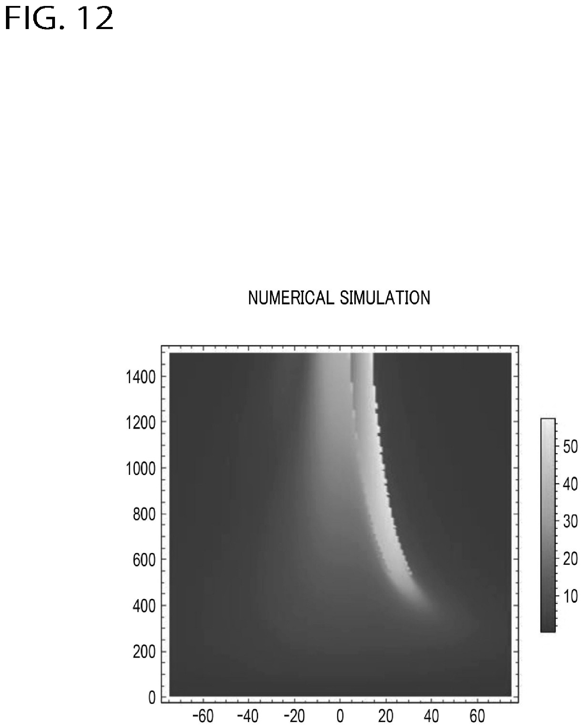

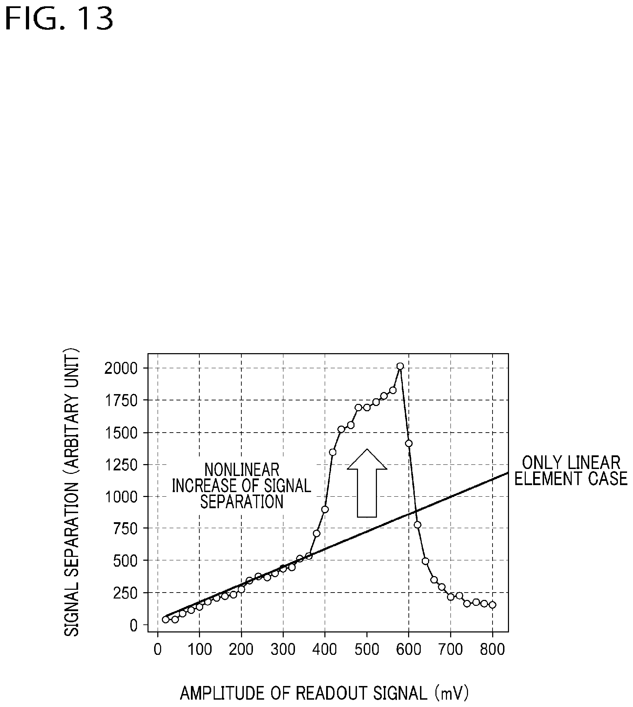

Figure 11 shows an experimental result of the wavelength characteristics of the nonlinear filter according to the present disclosure. Figure 12 shows a numerical simulation result of the wavelength characteristics of the nonlinear filter according to the present disclosure. Figure 13 shows the relationship between the amplitude of the readout signal and the signal separation obtained from the experimental result in Figure 11.

(Experiment 2)

The following are the parameters of the quantum device used in the experiment.

Transition frequency of data qubits: $\omega_q/2\pi$ = 8.4969 GHz. Energy relaxation time: T1 = 17 = 1 $\mu$sec.

The readout resonator is a A/2 resonator with a intrinsic Purcell filter as described in Non-Patent Literature 8, with Dressed Qubit resonance frequency $\omega_c/2\pi$ = 9.7927 GHz. Dispersion shift: $\chi$ = -11.8 MHz.

Anharmonicity of nonlinear filter: $\alpha_f/2\pi$ = -0.12 GHz. Coupling coefficient between readout resonator and nonlinear filter: g/2$\pi$ = 88 MHz.

Line width of the nonlinear filter: $\kappa_f$ = 0.31 GHz.

The following experiment was performed using two readout pulses with periods of 200 ns and 40 ns.

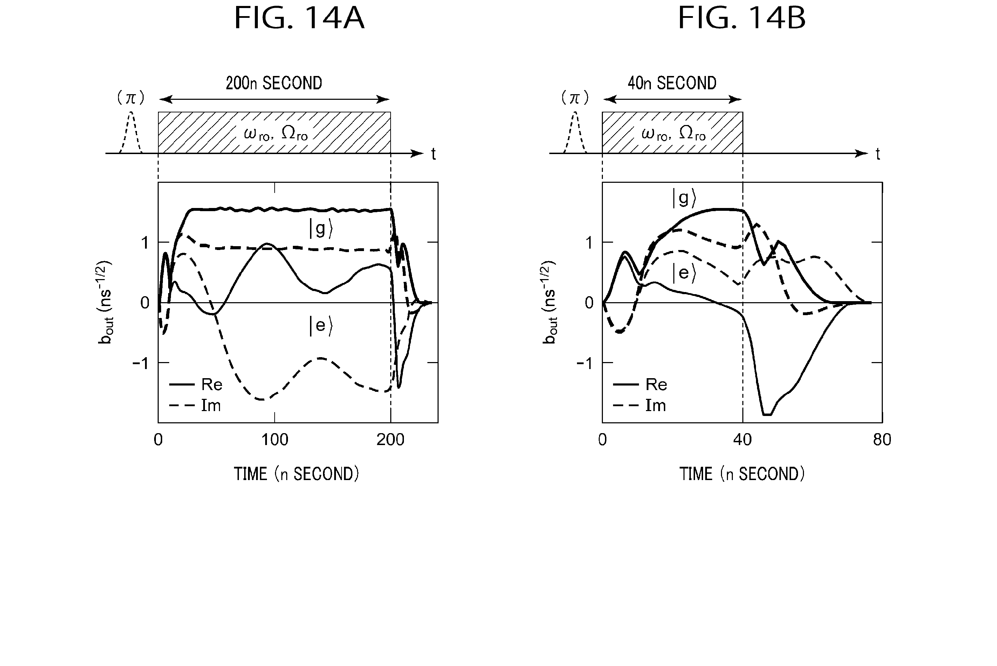

Figure 14 shows the temporal change of the readout signal $b_{out}$, normalized so that $|b_{out}|^2$ is equal to the photon flux, in the excited state (|e>) and ground state (|g>). Figure 14(a) corresponds to a readout pulse length of 200 ns, and Figure 14(b) corresponds to a readout pulse length of 40 ns.

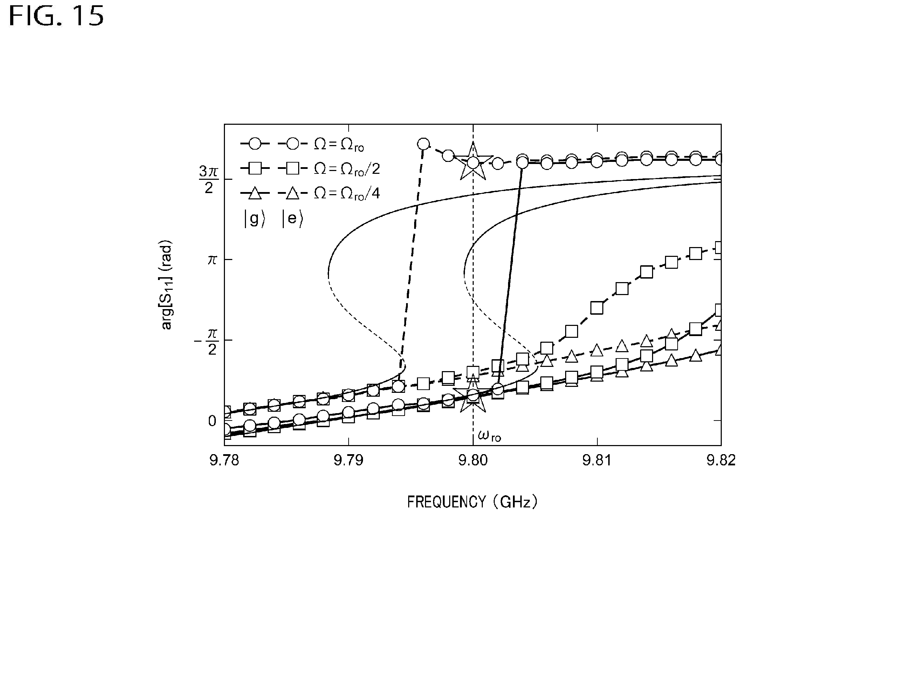

Figure 15 shows the phase of the steady-state reflection coefficient $S_{11}$ of the nonlinear filter with respect to the frequency and amplitude of the input signal. Specifically, this is the reflection spectrum of the nonlinear filter measured using 2 microsecond rectangular pulses of various frequencies and amplitudes. The theoretical curves were calculated using steady-state solutions of the classical equations of motion that approximate the mean-field dynamics of the readout resonator. The reflection coefficients measured at the frequency $\omega_{ro}$ and amplitude $\Omega_{ro}$ of the readout pulse are indicated by stars.

When the amplitude of the input signal is small, the measured spectrum agrees well with the classical model. This can be used to determine the anharmonicity of the filter. However, the classical model branches near the frequency and amplitude of the readout pulse. The readout signal in the ground state |g> is on the low excitation branch. In contrast, the readout signal for the excited state |e> does not strictly follow the classical model, however, it is considered to be on the high excitation branch.

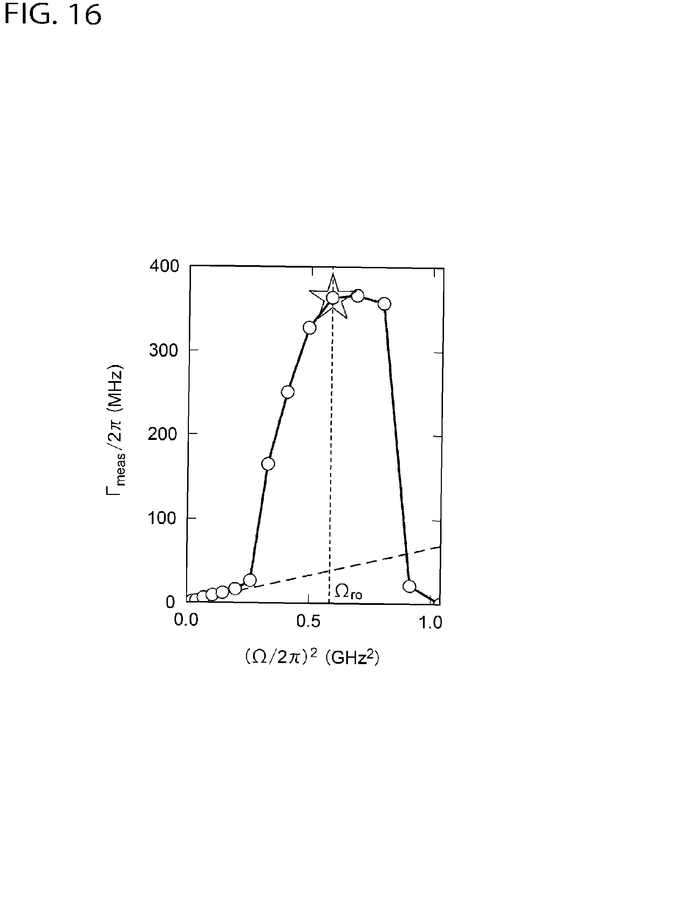

Figure 16 shows the observed measurement rate $\Gamma_{meas}$ as a function of the amplitude of the readout pulse. The measurement rate $\Gamma_{meas}$ is calculated as follows.

$$\Gamma_{meas} = \left| b^e_{out} - b^g_{out} \right| / 2$$

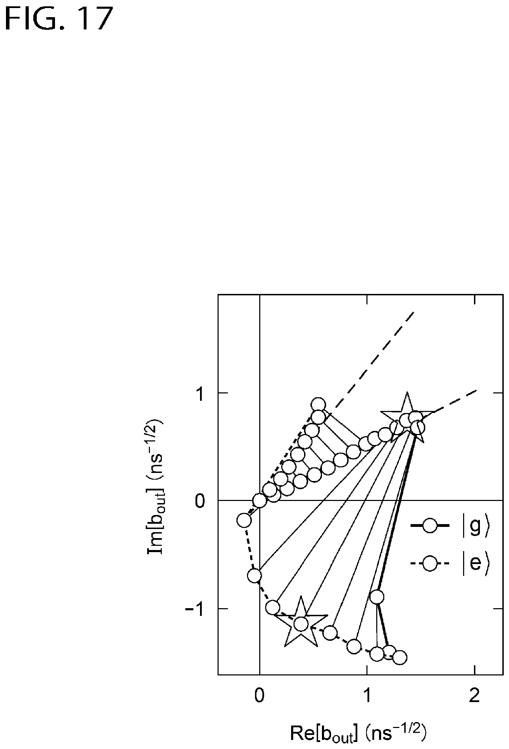

where $b^e_{out}$ and $b^g_{out}$ are the complex amplitudes of the readout signal in the excited state |e> and ground state |g>, respectively. Here, they are normalized so that $|b_{out}|^2$ is equal to the photon flux. These complex amplitudes were measured using 2 microsecond square pulses. The results are shown in Figure 17.

As shown in Figure 16, the magnitude of $\Gamma_{meas}$, i.e., the difference in amplitude of the readout signal between the excited state |e> and the ground state |g> $|b^e_{out} - b^g_{out}|$, is larger around the readout pulse. This can be attributed to the fact that they are on different branches. This improves the measurement rate by a factor of about 9 compared to a device using a linear filter with equivalent noise tolerance.

The invention has been described above in terms of embodiments. It is understood by those skilled in the art that these embodiments are examples, that various variations are possible in the combination of their respective components and respective processing processes, and that such variations are also within the scope of the invention.

Any combination of the above mentioned embodiments and variations is also useful as an embodiment of the invention. The new embodiment resulting from the combination will have the combined effects of each of the embodiments and variations.

Industrial applicability.

The invention is a quantum device and a quantum computer.

REFERENCE SIGNS LIST

10. Quantum device,
11. Qubit,
12. Readout resonator,
13. Readout waveguide,
14. Nonlinear filter,
15. Filter qubit,
20. Transmon-based nonlinear filter,
21. Capacitor,
22. Josephson junction,
30. Quantum device,
31. data qubit,
32. Readout resonator,
33. Readout waveguide,
34. Nonlinear filter,
35. Capacitor,
36. Capacitor,
37. Capacitor,
40. Quantum device,
41. Data qubit,
42. Readout resonator,
43. Readout waveguide,

44. Nonlinear filter,
45. Capacitor,
46. Capacitor,
47. Inductor,
100. System for dispersive readout,
110. Quantum device,
101. Qubit,
102. Readout resonator,
103. Readout waveguide,
104. Linear filter.


**Claims**

1. A quantum device comprising:

   a data qubit;
   a readout resonator coupled with the data qubit; and
   a nonlinear filter inserted between the readout resonator and a readout waveguide,
   wherein the nonlinear filter has different transparency depending on the amplitude of the readout pulse input to the readout waveguide.

2. The quantum device according to claim 1,
   wherein the nonlinear filter has high transparency for input signals of small amplitude and low transparency for input signals of large amplitude.

3. The quantum device according to claim 2,
   wherein the nonlinear filter has a transparency such that $\kappa_{eff} \gg \chi$ when no readout of the data qubit is performed and $\kappa_{eff} = \chi$ during readout, where the line width of the coupling between the readout resonator and the readout waveguide through the nonlinear filter is $\kappa_{eff}$ and the dispersion shift of the readout resonator due to the data qubit is $\chi$.

4. The quantum device according to claim 3,
   wherein the nonlinear filter comprises a superconducting qubit.

5. The quantum device according to claim 4,
   wherein the nonlinear filter has the following features of:
   [Equation 8]

$$\left| \omega_f - \omega_r \right| \ll \kappa, \qquad (4)$$

   [Equation 9]

$$\alpha_f \gtrsim \kappa, \qquad (5)$$

   [Equation 10]

$$\kappa \approx 4g, \qquad (6)$$

   [Equation 11]

$$\kappa \gg \chi \qquad (7)$$

where the transition frequency of the nonlinear filter is $\omega_f$, the anharmonicity of the nonlinear filter is $\alpha_f$, the resonance frequency of the readout resonator is $\omega_r$, the coupling strength between the readout resonator and the nonlinear filter is g and the line width of coupling between the nonlinear filter and the readout waveguide is κ.

6. The quantum device according to claim 5,
   wherein the superconducting qubit comprises a transmon consisting of a Josephson junction and a capacitor coupled with each other in parallel.

7. The quantum device according to claim 6,
   wherein the nonlinear filter and the readout waveguide are capacitively coupled.

8. The quantum device according to claim 6,
   wherein the nonlinear filter and the readout waveguide are inductively coupled.

9. A quantum computer comprising:
   the quantum device according to any one of claims 1 to 8.

FIG. 1

EP 4 766 127 A1

FIG. 2

100

SYSTEM FOR DISPERSIVE READOUT

101

DATA QUBIT

102

READOUT RESONATOR

READOUT PULSE

103

READOUT WAVEGUIDE

READOUT SIGNAL

(LOW TEMPERATURE ENVIRONMENT)

WAVEFORM MEASURING DEVICE (ROOM TEMPERATURE ENVIRONMENT)

EP 4 766 127 A1

FIG. 3

EP 4 766 127 A1

# FIG. 4

QUANTUM DEVICE — 10

11 DATA QUBIT

DISPERSION SHIFT $X$

12 READOUT RESONATOR

14 NONLINEAR FILTER

13 READOUT WAVEGUIDE

READOUT PULSE (AMPLITUDE $V_{meas}$)

COUPLING LINE WIDTH (DEPEND ON INPUT SIGNAL AMPLITUDE V) $K_{eff}(V)$

THERMAL NOISE $(V_{th})$

EP 4 766 127 A1

# FIG. 5

PHASE RELAXATION RATE $\Gamma_\phi$

DURING READOUT

NORMAL OPERATION

$K_{eff} = 0$      $K_{eff} = X$      $K_{eff} \gg X$

LINE WIDTH OF READOUT RESONATOR $K_{eff}$

EP 4 766 127 A1

FIG. 6

EP 4 766 127 A1

# FIG. 7

EP 4 766 127 A1

TRANSMISSION FREQUENCY $\omega_q$
ANHARMONICITY $\alpha_q$    RESONANCE FREQUENCY $\omega_r$    TRANSMISSION FREQUENCY $\omega_f$
ANHARMONICITY $\alpha_f$    READOUT PULSE
FREQUENCY $\omega_r$

**11**    **12**    **15**    **13**

DATA QUBIT — DISPERSION SHIFT X — READOUT RESONATOR — COUPLING STRENGTH g — FILTER QUBIT — COUPLING LINE WIDTH K — READOUT WAVEGUIDE

# FIG. 8

21

22

20

FIG. 9

30

FIG. 10

40

# FIG. 11

EXPERIMENTAL RESULT

FIG. 12

NUMERICAL SIMULATION

# FIG. 13

FIG. 14A      FIG. 14B

FIG. 15

EP 4 766 127 A1

# FIG. 16

FIG. 17

## INTERNATIONAL SEARCH REPORT

| International application No. |
| --- |
| **PCT/JP2024/029139** |

| **A.** | **CLASSIFICATION OF SUBJECT MATTER** |
| --- | --- |

*H10N 60/12*(2023.01)i
FI: H10N60/12 Z ZAA

According to International Patent Classification (IPC) or to both national classification and IPC

| **B.** | **FIELDS SEARCHED** |
| --- | --- |

Minimum documentation searched (classification system followed by classification symbols)

H10N60/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| **C.** | **DOCUMENTS CONSIDERED TO BE RELEVANT** | |
| --- | --- | --- |

| Category* | Citation of document, with indication, where appropriate, of the relevant passages | Relevant to claim No. |
| --- | --- | --- |
| A | JEFFREY, E et al., Fast Accurate State Measurement with Superconducting Qubits, PHYSICAL REVIEW LETTERS, 2014. 05, vol. 112, no. 190504<br>particularly, page 1, left column, line 28 to page 2, left column, line 43, fig. 1 | 1-9 |
| A | REED, M. D et al., Fast Reset and Suppressing Spontaneous Emission of a Superconducting Qubit, Applied Physics Letter, 2010. 05, vol. 96, no. 203110<br>particularly, page 1, left column, line 23 to page 2, left column, line 28, fig. 1 | 1-9 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **10 October 2024** | **22 October 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**REFERENCES CITED IN THE DESCRIPTION**

**Non-patent literature cited in the description**

- **T. WALTER et al.** Rapid high-fidelity single-shot dispersive readout of superconducting qubits. *Physical Review Applied*, 26 May 2017, vol. 7, 054020
- **M. D. REED et al.** Fast reset and suppressing spontaneous emission of a superconducting qubit. *Applied Physics Letters*, 2010, vol. 96, 203110
- **E. JEFFREY et al.** Fast accurate state measurement with superconducting qubits. *Physical Review Letters*, 2014, vol. 112, 190504
- **E. A. SETE et al.** Quantum theory of a bandpass Purcell filter for qubit readout. *Physical Review A*, 2015, vol. 92, 012325
- **N. T. BRONN et al.** Broadband filters for abatement of spontaneous emission in circuit quantum electrodynamics. *Applied Physics Letters*, 2015, vol. 107, 172601
- **N. T. BRONN et al.** Reducing spontaneous emission in circuit quantum electrodynamics by a combined readout/filter technique. *IEEE Transactions on Applied Superconductivity*, 2015, vol. 25, 1700410
- **L. C. G. GOVIA et al.** Enhanced qubit readout using locally generated squeezing and inbuilt Purcell-decay suppression. *New Journal of Physics*, 2017, vol. 19, 023044

- **Y. SUNADA et al.** Fast readout and reset of a superconducting qubit coupled to a resonator with an intrinsic Purcell filter Physical. *Physical Review Applied*, 2022, vol. 17, 044016
- **K. KOSHINO et al.** Protection of a Qubit via Subradiance: A Josephson Quantum Filter. *Physical Review Applied*, 2020, vol. 13, 014051
- **S. KONO et al.** Breaking the trade-off between fast control and long lifetime of a superconducting qubit. *Nature Communications*, 2020, vol. 11, 3683
- **I. IAKOUPOV et al.** Saturable Purcell filter for circuit quantum electrodynamics. *Physical Review Research*, 2023, vol. 5, 013148
- **J.-H. YEH et al.** Microwave attenuators for use with quantum devices below 100 mK. *Journal of Applied Physics*, 2017, vol. 121, 224501
- **F. YAN et al.** Distinguishing Coherent and Thermal Photon Noise in a Circuit Quantum Electrodynamical System. *Physical Review Letters*, 2018, vol. 120, 260504
- **Z. WANG et al.** Cavity attenuators for superconducting qubits. *Physical Review Applied*, 2019, vol. 11, 014031
- **A. BLAIS et al.** Circuit quantum electrodynamics. *Reviews of Modern Physics*, 2021, vol. 93, 025005